# EUROPEAN PATENT SPECIFICATION

(11) **EP 2 214 791 B1**
(45) Date of publication and mention of the grant of the patent: **16.11.2016**
(21) Application number: 07846897.2
(22) Date of filing: 29.11.2007
(51) Int. Cl.: A62B 7/14, A62B 27/00, G01R 31/00

(54) **TEST EQUIPMENT AND METHOD FOR TESTING AN AIRCRAFT OXYGEN SYSTEM CONTROL DEVICE**
TESTAUSRÜSTUNG UND VERFAHREN ZUM TESTEN EINER STEUERVORRICHTUNG EINES FLUGZEUGSAUERSTOFFSYSTEMS
EQUIPEMENT DE TEST ET PROCÉDÉ POUR TESTER UN DISPOSITIF DE COMMANDE DU SYSTÈME D'OXYGÈNE D'UN AVION

(43) Date of publication of application: 11.08.2010
(73) Proprietor: Airbus Operations GmbH, 21129 Hamburg (DE)
(72) Inventor: QUAST, Dirk, 21129 Hamburg (DE)
(74) Representative: Katérle, Axel
(86) International application number: PCT/EP2007/010372
(87) International publication number: WO 2009/068058

(56) References cited:
- US-A- 2 934 293
- US-A- 3 615 250
- US-A- 4 475 196
- US-A- 5 071 453
- US-A1- 2005 145 245

## Description

The present invention relates to test equipment and a method for testing an aircraft oxygen system control device.

Modern passenger aircraft are equipped with emergency oxygen systems in order to provide oxygen to the passengers and/or crew in case of a drop in cabin pressure. Two types of oxygen source are commonly known for use in emergency oxygen systems. As one type, pressure cylinders containing gaseous oxygen may be used. As another type, oxygen may be generated by chemical reaction using suitable reagents. An aircraft emergency oxygen system may rely on either or both types of oxygen source. Onboard oxygen generation by chemical reaction is in many cases considered to be appropriate particularly for cases of short required supply times. Where longer oxygen supply times are required, pressure cylinders storing gaseous oxygen may be advantageous from a weight point of view. The present invention is particularly concerned with gaseous emergency oxygen systems using pressure cylinders. This, however, must not be construed as implying a limitation of the invention to such gaseous systems. In fact, application of the present invention to chemical emergency oxygen systems may be envisaged, as well.

In a gaseous emergency oxygen system, an oxygen distribution system distributes oxygen from several pressure cylinders (typically, a plurality of cylinders are employed, but using a single pressure cylinder is also within the scope of the present invention) to a plurality of oxygen masks, which passengers and/or crew must pull over their face in order to breathe the supplemental oxygen. One or more regulator valves installed in the distribution system are used to regulate the amount of oxygen supplied to the masks according to such requirements as a certain mean tracheal oxygen partial pressure to be ensured by the masks in order not to risk harm to the health of the passengers and crew. The regulator valves are controlled by an oxygen system control device.

The oxygen system control device conventionally receives detector signals from various detectors detecting operational conditions of the emergency oxygen system. The aircraft cockpit and/or cabin is equipped with oxygen system condition indicators to allow the crew to learn of abnormal conditions of the emergency oxygen system and take appropriate countermeasures, if needed and possible. The oxygen system condition indicators may include indicators that are only activated in case of abnormal situations, e.g., a warning lamp or tone. Alternatively or additionally, there may be indicators providing a continuous indication of a specific operation parameter of the emergency oxygen system, leaving it to the crew to monitor the indicator and decide when an abnormal situation has occurred. The oxygen system control device processes the received detector signals and outputs control signals for controlling the indicators, either directly or indirectly via suitable intermediate circuitry.

The detector signals may come from such detectors as an oxygen distribution system pressure sensor, an oxygen cylinder pressure transducer and an oxygen cylinder temperature sensor. The oxygen distribution system pressure sensor responds to the pressure in the oxygen distribution system. It may be an on/off detector providing a high signal when the pressure in the oxygen distribution system is above (below) a certain value and a low signal when the pressure in the oxygen distribution system is below (above) that value. The oxygen cylinder pressure transducer may provide a signal indicative of the pressure in an oxygen cylinder. Where more than one cylinder are provided, an oxygen cylinder pressure transducer may be associated with each cylinder. The oxygen system control device may calculate an average cylinder pressure from the signals of the various oxygen cylinder pressure transducers. The oxygen cylinder temperature sensor may sense the ambient temperature in the area of the one or more pressure cylinders. The oxygen system control device may use the measured temperature for calculating a temperature-compensated average cylinder pressure.

US 2005/0145245 A1 discloses functional testing of aircrew equipment It is an object of the present invention to provide test equipment that allows easy and reliable testing of an aircraft oxygen system control device of the general type described above. It is a further object of the present invention to provide a simple testing method using such test equipment.

According to the present invention, there is provided test equipment for testing an aircraft oxygen system control device as defined in claim 1.

The switch means may comprise a plurality of individually operable switches associated with respective different test signal outputs. In a preferred embodiment, the switch means may comprise an individually operable switch in relation to each test signal output.

Advantageously, the switch means are manually operable. Provision of a software program module effective to automatically operate the switch means according to a predetermined switching scheme may be likewise conceivable.

The test signal switching module may comprise a test signal output for connection to an oxygen distribution system pressure signal input of the aircraft oxygen system control device. Alternatively or additionally, the switching module may comprise at least one test signal output for connection to an oxygen cylinder pressure signal input of the aircraft oxygen system control device. In addition or alternative to either of the mentioned test signal outputs, the switching module may comprise a test signal output for connection to an oxygen cylinder temperature signal input of the aircraft oxygen system control device. It is to be understood that the switching module is not limited to comprising test signal outputs for connection to the mentioned signal inputs of the control device. The switching module may be provided with one or more test signal outputs for connection to other signal inputs of the control device, as well.

In one embodiment, the test signal switching module may comprise one ore more test signal inputs for receiving an external test signal on each test signal input, wherein the test signal switching module is configured to route each received test signal via the switch means to at least one test signal output. Alternatively or additionally, the switching module may be configured to generate one or more test signals internally.

Advantageously, the test equipment further comprises connection cable means for connecting the one or more test signal outputs of the test signal switching module to the one or more detector signal inputs of the aircraft oxygen system control device and/or for connecting the one or more test signal inputs of the test signal switching module to one or more test signal outputs of the aircraft oxygen system control device.

In a preferred embodiment of the method of the present invention, test signals are supplied simultaneously to each of a plurality of detector signal inputs of the aircraft oxygen system control device. The switch means of the test signal switching module are then operated to successively switch the test signals supplied to different detector signal inputs on and off, wherein a test signal previously switched off is switched back on before a next test signal is switched off. In this manner, the control device can be tested for proper reaction to abrupt signal drops or signal failure at any one of the detector signal inputs.

The invention will be described further hereinafter in conjunction with the accompanying drawings, in which:
Figure 1 shows a schematic layout of an aircraft emergency oxygen system,
Figure 2 schematically illustrates a switching box connected to an oxygen system control device of the emergency oxygen system of figure 1, and
Figure 3 schematically shows a circuit block diagram of the switching box of figure 2.

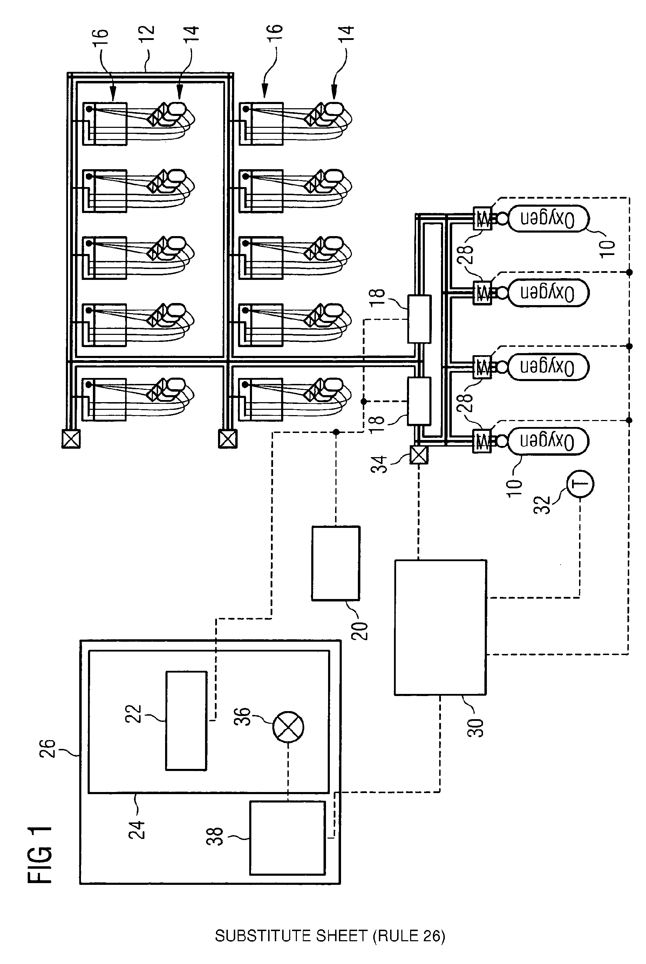

In the exemplary embodiment depicted in figure 1, the emergency oxygen system comprises a plurality of pressure cylinders 10 containing gaseous oxygen. Four pressure cylinders 10 are shown in Figure 1 altogether. It is to be understood that the number of pressure cylinders is not relevant to the invention and may be smaller or larger than four, depending on such parameters as the passenger capacity of the aircraft, the size of the cylinders, etc. The pressure cylinders 10 are connected to an oxygen distribution system generally designated 12. The oxygen distribution system 12 distributes oxygen from the cylinders 10 to a plurality of oxygen masks 14 stored in mask containers 16 above the passenger seats of the aircraft. In an emergency case, the oxygen masks 14 will drop down from the containers 16 and will be pulled by the passengers over their face. The oxygen distribution system 12 includes one or more (in the illustrated embodiment two) oxygen regulator valves 18 regulating the amount of oxygen flowing in the distribution system 12. The valves 18 are activated either automatically by means of an altitude switch 20 or manually by means of an activation switch 22 provided on an overhead control panel 24 in a cockpit 26 of the aircraft.

The cylinder pressure of each cylinder 10 is reduced by means of a pressure reduction valve 28 having an integrated pressure transducer to generate an electric pressure signal indicative of the pressure in the cylinder. The pressure signals of the reduction valves 28 are provided to an oxygen system control device 30, which processes the received pressure signals to calculate a mean arithmetic value of the pressure in the cylinders 10. A temperature sensor 32 generates a temperature signal indicative of the ambient temperature in the area where the pressure cylinders 10 are located. The control device 30 receives the temperature signal to compensate for temperature-dependent variations of the pressure in the cylinders 10. In this way, a temperature-compensated average cylinder pressure is calculated by the control device 30.

A low pressure switch 34 detects a low pressure condition in the oxygen distribution system 12. The pressure switch 34 is an on/off switch which is in an on-state under normal operating conditions of the emergency oxygen system, i.e., when the pressure in the oxygen distribution system is above a certain level. When the pressure in the distribution system 12 drops below that level, the pressure switch 34 opens and changes its state to off. The pressure switch 34 provides a high/low signal to the control device 30 based on its switching state.

The pressure reduction valves 28, the temperature sensor 32 and the pressure switch 34 are all detectors which detect operating conditions of the emergency oxygen system. If any of the detected conditions shows an abnormal situation of the emergency oxygen system, a warning should be output to the crew of the aircraft. To this end, the control device 30 processes the various received detector signals and generates one or more control signals for controlling one or more oxygen system condition indicators provided in the cockpit 26 of the aircraft. An example of an oxygen system condition indicator can be a warning lamp 36 provided on the control panel 24, which is activated when the pressure switch 34 opens and/or the temperature-compensated average cylinder pressure falls below a predetermined threshold value. Alternatively or additionally, the warning indicator 36 should be activated when the temperature sensor 32 and/or any one of the pressure reduction valves 28 no longer provides a signal to the control device 10, e.g., because of failure. In any such abnormal situation, the control device 10 outputs a suitable control signal to an electronic centralized aircraft monitor (ECAM) unit 38 to trigger the same to activate the indicator 36.

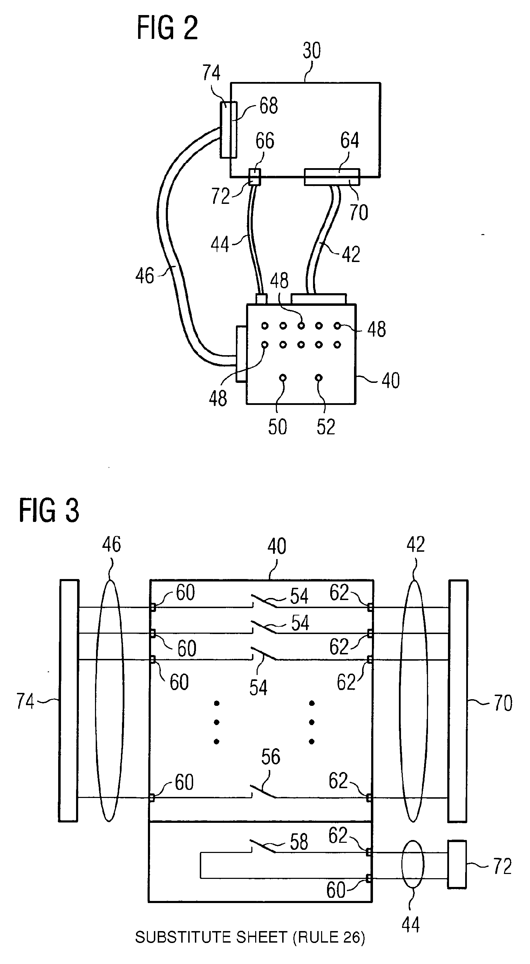

Reference is now made additionally to Figures 2 and 3. A test signal switching box 40 is shown in these figures. The switching box 40 will be connected to the control device 30 for testing purposes in place of the detectors 28, 32, 34. As particularly shown in Figure 2, the switching box 40 can be connected to the control device 30 by means of a set of connection cables 42, 44, 46. It is to be understood that all connection lines between the switching box 40 and the control device 30 may be combined in a single connection cable, for example. The number of connection cables needed will depend, e.g., on such factors as the location of connection interface on the control device 30 and the switching box 40.

The switching box 40 comprises a plurality of switch operating elements 48, 50, 52 on a user operation panel of the box 40. In the exemplary embodiment of Figure 2, a total of ten switch operating elements 48 are provided on the switching box 40, whereas a single switch operating element 50 and a single switch operating element 52 are provided. The switch operating elements 48, 50, 52 can be in the form of rotatable knobs or pushbuttons, for example. Each switch operating element 48, 50, 52 has its own associated switch 54, 56 and 58, respectively, inside the switching box 40. Specifically, a switch 54 is associated to each switch operating element 48, a switch 56 is associated to the switch operating element 50, and a switch 58 is associated to the switch operating element 52.

The switches 54, 56, 58 are positioned in test signal lines extending between respective test signal inputs 60 and respective test signal outputs 62 of the switching box 40. The test signal inputs 60 each serve to receive a test signal, which may then be switched on and off using one of the switches 54, 56, 58 and may be output from the switching box 40 at a respective test signal output 62. The input test signals may be in the form of a constant voltage signal such as, e.g., a supply voltage signal. In the embodiment illustrated in Figures 2 and 3, the test signals are generated by the control device 30 and supplied to the switching box 40 via the connection cables 44, 46. After passing the switches, the test signals are transmitted via the connection cables 42, 44 to the detector signal inputs of the control device 30. In this way, the control device 30 can be tested for proper reaction on a low signal (corresponding to a switched-off test signal) at any one of the detector signal inputs.

As shown in Figure 2, the control device 30 comprises connection interfaces 64, 66, 68, to which cable connectors 70, 72, 74 of the connection cables 42, 44, 46 can be connected. The connection interface 64 includes one detector signal input which, during operation of the emergency oxygen system, receives the temperature signal from the temperature sensor 32. The connection interface 64 includes further detector signal inputs for receiving pressure signals from the pressure reduction valves 28. The connection interface 64 provides a separate detector signal input for each such pressure signal. There may be more detector signal inputs for reception of pressure signals from pressure reduction valves 28 than the number of pressure containers 10 actually installed. In such a case, some of the detector signal inputs will be left unconnected during normal operation of the aircraft. The switching module 40, however, is configured to provide a test signal to each detector signal input of the connection interface 64. To this end, it includes a number of switches 54 that is the same as the number of detector signal inputs provided in the connection interface 64 for receipt of pressure signals from pressure reduction valves 28. For example, there may be ten switches 54 provided in the switching module 40 and ten corresponding switch operation elements 48.

The switch 56 is associated with a test signal line leading to the temperature signal input of the connection interface 64.

The connection interface 66 of the control device 30 includes an input for receipt of the signal from the pressure switch 34 during operation of the emergency oxygen system and further includes a voltage output providing a predetermined voltage signal that may serve as an input test signal to the switch 58 of the switching module 40.

The connection interface 68, finally, includes a test signal output in relation to each of the switches 54, 56 for providing test signals to these switches. It is understood that a single test signal output of the control device 30 may be sufficient to provide test signals to all test signal inputs 60 of the switching module 40.

During testing operation, the switches 54, 56, 58 may be initially brought in a closed state to generate a high signal state at each detector signal input of the control device 30. Thereafter, one of the switches 54, 56, 58 may be switched off using the associated switch operating element 48, 50 or 52 to thereby generate a low signal state at one of the detector signal inputs of the control device 30. The control device 30, if functioning properly, should respond to the low signal state by triggering the ECAM unit 38 to activate the warning indicator 36 or any other suitable oxygen system condition indicator. The operated switch is subsequently reset to its closed state, whereupon another switch is opened using its associated switch operating element. In this way, by successively actuating the switches 54, 56, 58 individually, the control device 30 can be tested for proper reaction on varying signal states at each of its detector signal inputs.

## Claims

1. A method of testing an aircraft oxygen system control device (30) comprising one or more detector signal inputs for receiving detector signals representative of one or more conditions of an aircraft gaseous oxygen system, wherein the aircraft oxygen system control device is configured to generate one or more control signals for controlling one or more oxygen system condition indicators based on the received one or more detector signals, wherein the method comprises the steps of:
- providing test equipment (40, 42, 44, 46) comprising a test signal switching module (40) having one or more test signal outputs (62) for providing test signals, the test signal switching module comprising switch means (54, 56, 58) for switching on and off the test signals,
- connecting test signal outputs of the test signal switching module to detector signal inputs of the control device (30) in place of respective detectors,
- supplying a test signal from at least one test signal output (62) of the test signal switching module (40) to at least one detector signal input,
- operating the switch means (54, 56, 58) of the test signal switching module (40) to change the test signal between on and off states, and
- monitoring at least one of the one or more oxygen system condition indicators (36).

2. The method of claim 1, further comprising the steps of:
- supplying test signals simultaneously to each of a plurality of detector signal inputs of the aircraft oxygen system control device (30),
- operating the switch means (54, 56, 58) of the test signal switching module (40) to successively switch the test signals supplied to different detector signal inputs on and off, wherein a test signal previously switched off is switched back on before a next test signal is switched off.

3. The method of claim 1 or 2, wherein the switch means comprise a plurality of individually operable switches (54, 56, 58) associated with respective different test signal outputs (62).

4. The method of claim 3, wherein the switch means comprise an individually operable switch (54, 56, 58) in relation to each test signal output (62).

5. The method of any one preceding claim, wherein the switch means (54, 56, 58) are manually operable.

6. The method of any one preceding claim, wherein the test signal switching module (40) comprises a test signal output (62) for connection to an oxygen distribution system pressure signal input of the aircraft oxygen system control device (30).

7. The method of any one preceding claim, wherein the test signal switching module (40) comprises at least one test signal output (62) for connection to an oxygen cylinder pressure signal input of the aircraft oxygen system control device (30).

8. The method of any one preceding claim, wherein the test signal switching module (40) comprises a test signal output (62) for connection to an oxygen cylinder temperature signal input of the aircraft oxygen system control device (30).

9. The method of any one preceding claim, wherein the test signal switching module (40) comprises one or more test signal inputs (60) for receiving an external test signal on each test signal input, the test signal switching module configured to route each received test signal via the switch means (54, 56,58) to at least one test signal output (62).

10. The method of any one preceding claim, further comprising using connection cable means (42, 44, 46) for connecting the one or more test signal outputs (62) of the test signal switching module (40) to the one or more detector signal inputs of the aircraft oxygen system control device (30) and/or for connecting the one or more test signal inputs (60) of the test signal switching module (40) to one or more test signal outputs of the aircraft oxygen system control device (30).

## Patentansprüche

1. Verfahren zum Testen einer Steuervorrichtung (30) eines Flugzeug-Sauerstoffsystems, die ein oder mehrere Detektorsignaleingänge zum Empfangen von Detektorsignalen aufweist, die für einen oder mehrere Zustände eines Flugzeug-Sauerstoffgassystems repräsentativ sind, wobei die Steuervorrichtung des Flugzeug-Sauerstoffsystems konfiguriert ist, ein oder mehrere Steuersignale zum Steuern eines oder mehrerer Indikatoren für den Zustand des Sauerstoffsystems auf Basis der empfangenen einen oder mehreren Detektorsignale zu erzeugen, wobei das Verfahren die Schritte aufweist:
- Bereitstellen einer Testausrüstung (40, 42, 44, 46), die ein Testsignal-Schaltmodul (40) mit einem oder mehreren Testsignalausgängen (62) zum Bereitstellen von Testsignalen aufweist, wobei das Testsignal-Schaltmodul Schaltmittel (54, 56, 58) zum Ein- und Ausschalten der Testsignale aufweist,
- Verbinden der Testsignalausgänge des Testsignal-Schaltmoduls mit den Detektorsignaleingängen der Steuervorrichtung (30) anstelle der jeweiligen Detektoren,
- Senden eines Testsignals von mindestens einem Testsignalausgang (62) des Testsignal-Schaltmoduls (40) an mindestens einen Detektorsignaleingang,
- Betätigen der Schaltmittel (54, 56, 58) des Testsignal-Schaltmoduls (40), um das Testsignal zwischen dem An- und Aus-Zustand zu wechseln, und
- Überwachen mindestens eines des einen oder der mehreren Indikatoren (36) für den Zustand des Sauerstoffsystems.

2. Verfahren nach Anspruch 1, das ferner die Schritte aufweist:
- gleichzeitiges Senden von Testsignalen an jeden der Mehrzahl Detektorsignaleingänge der Steuervorrichtung (30) des Flugzeug-Sauerstoffsystems,
- Betätigen der Schaltmittel (54, 56, 58) des Testsignal-Schaltmoduls (40), um die zu den verschiedenen Detektorsignaleingängen gesendeten Testsignale nacheinander ein- und auszuschalten, wobei ein zuvor ausgeschaltetes Testsignal wieder eingeschaltet wird, bevor ein nächstes Testsignal ausgeschaltet wird.

3. Verfahren nach Anspruch 1 oder 2, wobei das Schaltmittel eine Mehrzahl individuell betätigbarer Schalter (54, 56, 58) aufweist, die jeweils verschiedenen Testsignalausgängen (62) zugeordnet sind.

4. Verfahren nach Anspruch 3, wobei die Schaltmittel einen individuell betätigbaren Schalter (54, 56, 58) bezüglich jedes Testsignalausgangs aufweisen.

5. Verfahren nach einem der vorigen Ansprüche, wobei die Schaltmittel (54, 56, 58) manuell betätigbar sind.

6. Verfahren nach einem der vorigen Ansprüche, wobei das Testsignal-Schaltmodul (40) einen Testsignalausgang (62) zum Anschluss an einen Sauerstoffverteilungssystem-Drucksignaleingang der Steuervorrichtung (30) des Flugzeug-Sauerstoffsystems aufweist.

7. Verfahren nach einem der vorigen Ansprüche, wobei das Testsignal-Schaltmodul (40) mindestens einen Testsignalausgang (62) zum Anschluss an einen Sauerstoffflaschen-Drucksignaleingang der Steuervorrichtung (30) des Flugzeug-Sauerstoffsystems aufweist.

8. Verfahren nach einem der vorigen Ansprüche, wobei das Testsignal-Schaltmodul (40) einen Testsignalausgang (62) zum Anschluss an einen Sauerstoffflaschen-Temperatursignaleingang der Steuervorrichtung (30) des Flugzeug-Sauerstoffsystems aufweist.

9. Verfahren nach einem der vorigen Ansprüche, wobei das Testsignal-Schaltmodul (40) einen oder mehrere Testsignaleingänge (60) zum Empfangen eines externen Testsignals an jedem Testsignaleingang aufweist, und das Testsignal-Schaltmodul konfiguriert ist, jedes empfangene Testsignal über die Schaltmittel (54, 56, 58) zu mindestens einem Testsignalausgang (62) zu leiten.

10. Verfahren nach einem der vorigen Ansprüche, das ferner die Verwendung von Verbindungskabelmitteln (42, 44, 46) aufweist, um den einen oder die mehreren Testsignalausgänge (62) des Testsignal-Schaltmoduls (40) mit dem einen oder den mehreren Testsignaleingängen der Steuervorrichtung (30) des Flugzeug-Sauerstoffsystems zu verbinden und/oder um den einen oder die mehreren Testsignaleingänge (60) des Testsignal-Schaltmoduls (40) mit einem oder mehreren Testsignalausgängen der Steuervorrichtung (30) des Flugzeug-Sauerstoffsystems zu verbinden.

## Revendications

1. Procédé de test d'un dispositif (30) de commande du circuit d'oxygène d'un aéronef comprenant une ou plusieurs entrées de signaux de détecteur destinées à recevoir des signaux de détecteurs représentatifs d'une ou de plusieurs conditions d'un circuit d'oxygène gazeux d'un aéronef, dans lequel le dispositif de commande du circuit d'oxygène d'aéronef est configuré pour générer un ou plusieurs signaux de commande pour commander un ou plusieurs indicateurs de condition du circuit d'oxygène sur la base d'un ou de plusieurs signaux de détecteurs reçus, dans lequel le procédé comprend les étapes consistant à :
- prévoir un équipement de test (40, 42, 44, 46) comprenant un module (40) de commutation de signaux de test comportant une ou plusieurs sorties (62) de signaux de test pour délivrer des signaux de test, le module de commutation de signaux de test comprenant un moyen de commutation (54, 56, 58) destiné à activer et désactiver les signaux de test,
- connecter les sorties de signaux de test du module de commutation de signaux de test aux entrées de signaux de détecteurs du dispositif de commande (30) à la place des détecteurs respectifs,
- délivrer un signal de test depuis au moins une sortie (62) de signal de test du module (40) de commutation de signaux de test vers au moins une entrée de signal de détecteur,
- actionner le moyen de commutation (54, 56, 58) du module (40) de commutation de signaux de test pour commuter les signaux de test entre des états actif et inactif, et
- contrôler au moins l'un parmi le ou les indicateurs (36) de condition du circuit d'oxygène.

2. Procédé selon la revendication 1, comprenant en outre les étapes consistant à :
- délivrer des signaux de test simultanément vers chacune parmi une pluralité d'entrées de signaux de détecteurs du dispositif (30) de commande du circuit d'oxygène d'aéronef,
- actionner le moyen de commutation (54, 56, 58) du module (40) de commutation de signaux de test pour activer et désactiver successivement les signaux de test délivrés vers différentes entrées de signaux de détecteurs, dans lequel un signal de test préalablement désactivé est à nouveau activé avant une nouvelle désactivation du signal de test.

3. Procédé selon la revendication 1 ou 2, dans lequel le moyen de commutation comprend une pluralité de commutateurs (54, 56, 58) actionnables individuellement associés aux différentes sorties (62) de signaux de test respectives.

4. Procédé selon la revendication 3, dans lequel le moyen de commutation comprend un commutateur (54, 56, 58) actionnable individuellement en relation avec chaque sortie (62) de signal de test.

5. Procédé selon l'une quelconque des revendications précédentes, dans lequel le moyen de commutation (54, 56, 58) est actionnable manuellement.

6. Procédé selon l'une quelconque des revendications précédentes, dans lequel le module (40) de commutation de signaux de test comprend une sortie (62) de signal de test pour connexion à une entrée de signal de pression du circuit de distribution d'oxygène du dispositif (30) de commande du circuit d'oxygène d'aéronef.

7. Procédé selon l'une quelconque des revendications précédentes, dans lequel le module (40) de commutation de signaux de test comprend au moins une sortie (62) de signal de test pour connexion à une entrée de signal de pression de cylindre d'oxygène du dispositif (30) de commande du circuit d'oxygène d'aéronef.

8. Procédé selon l'une quelconque des revendications précédentes, dans lequel le module (40) de commutation de signaux de test comprend une sortie (62) de signal de test pour connexion à une entrée de signal de température de cylindre d'oxygène du dispositif (30) de commande du circuit d'oxygène d'aéronef.

9. Procédé selon l'une quelconque des revendications précédentes, dans lequel le module (40) de commutation de signaux de test comprend une ou plusieurs entrées (60) de signaux de test destinées à recevoir un signal de test externe sur chaque entrée de signal de test, le module de commutation de signaux de test étant configuré pour acheminer chaque signal de test reçu via le moyen de commutation (54, 56, 58) vers au moins une sortie (62) de signal de test.

10. Procédé selon l'une quelconque des revendications précédentes, comprenant en outre l'utilisation d'un moyen (42, 44, 46) de câble de connexion pour connecter la ou les sorties (62) de signaux de test du module (40) de commutation de signaux de test à la une ou plusieurs entrées de signaux de détecteurs du dispositif (30) de commande du circuit d'oxygène d'aéronef et/ou pour connecter la ou les plusieurs entrées (60) de signaux de test du module (40) de commutation de signaux de test à une ou plusieurs sorties de signaux de test du dispositif (30) de commande du circuit d'oxygène d'aéronef.
